# EUROPEAN PATENT APPLICATION

(11) **EP 4 723 846 A1**
(43) Date of publication of application: **08.04.2026**
(21) Application number: 24838476.0
(22) Date of filing: 29.05.2024
(51) Int. Cl.: H10K 30/80, H10K 30/50, H10K 71/12, H10K 71/40, H10K 99/00

(54) **PEROVSKITE SOLAR CELL AND PREPARATION METHOD THEREFOR**

(30) Priority: 10.07.2023 CN 202310837997
(71) Applicant: Tongwei Solar (Chengdu) Co., Ltd., Chengdu, Sichuan 610299 (CN)
(72) Inventor: LI, Xuyang, Chengdu, Sichuan 610299 (CN); XING, Guoqiang, Chengdu, Sichuan 610299 (CN); LONG, Wei, Chengdu, Sichuan 610299 (CN); ZHANG, Yifeng, Chengdu, Sichuan 610299 (CN)
(74) Representative: Murgitroyd & Company
(86) International application number: PCT/CN2024/095979
(87) International publication number: WO 2025/011218

(57) **Abstract**

Disclosed are a perovskite solar cell and a preparation method therefor. The perovskite solar cell includes a perovskite layer (3), an electron transport layer (5) and a reduced graphene oxide layer (4). The reduced graphene oxide layer (4) includes polydopamine and reduced graphene oxide combined by means of a chemical reaction, or includes polydopamine and reduced graphene oxide combined by means of physical blending.

## Description

### CROSS-REFERENCE TO RELATED APPLICATIONS

The present application claims priority to Chinese Patent Application No. CN202310837997.5, filed with the China National Intellectual Property Administration on July 10, 2023 and entitled "PEROVSKITE SOLAR CELL AND PREPARATION METHOD THEREFOR", which is incorporated herein by reference in its entirety.

### TECHNICAL FIELD

The present disclosure relates to the field of solar cell technologies, and in particular, to a perovskite solar cell and a preparation method therefor.

### BACKGROUND

In a perovskite solar cell, there are a lot of defects at an interface between a perovskite layer and an electron transport layer, and free electrons generated by exciton dissociation on the interface are easy to recombine at these defects on the interface, which reduces an electron transfer efficiency and a power conversion efficiency of the perovskite solar cell.

### SUMMARY

According to some embodiments of the present disclosure, a perovskite solar cell is provided, including a perovskite layer, an electron transport layer and a reduced graphene oxide layer, where the reduced graphene oxide layer is located between the perovskite layer and the electron transport layer, and the reduced graphene oxide layer includes polydopamine and reduced graphene oxide combined by means of a chemical reaction, or the reduced graphene oxide layer includes polydopamine and reduced graphene oxide combined by means of physical blending.

In some embodiments of the present disclosure, a mass ratio of the polydopamine to the reduced graphene oxide ranges from 0.01:100 to 10:100.

In some embodiments of the present disclosure, a mass ratio of the polydopamine to the reduced graphene oxide ranges from 4:100 to 6:100.

In some embodiments of the present disclosure, the polydopamine is prepared from any one of dopamine hydrochloride, 5-hydroxydopamine hydrochloride or 6-hydroxydopamine hydrobromide.

In some embodiments of the present disclosure, a thickness of the reduced graphene oxide layer ranges from 15 nm to 20 nm.

In some embodiments of the present disclosure, a method for combining the polydopamine and the reduced graphene oxide includes: dissolving the polydopamine and the reduced graphene oxide in isopropanol and stirring for reaction, where a mass ratio of the polydopamine to the reduced graphene oxide ranges from 0.01:100 to 10:100.

In some embodiments of the present disclosure, in the step of combining the polydopamine and the reduced graphene oxide, after the reduced graphene oxide is mixed with the isopropanol, the mixture is dispersed by ultrasound first, and then the polydopamine is added.

In some embodiments of the present disclosure, in the step of combining the polydopamine and the reduced graphene oxide, after the polydopamine, the reduced graphene oxide and the isopropanol are mixed, a pH regulator is added to adjust a pH value to a range from 8 to 9, and the pH regulator includes one or more of sodium hydroxide, ammonia water and sodium carbonate.

In some embodiments of the present disclosure, in the step of combining the polydopamine and the reduced graphene oxide, a reaction temperature ranges from 75°C to 85°C, and a reaction time ranges from 20 hours to 28 hours.

In some embodiments of the present disclosure, the reduced graphene oxide is prepared by reducing graphene oxide, and a preparation method for the graphene oxide includes: dispersing graphene in a mixed solution of concentrated sulfuric acid and phosphorous acid, adding sodium nitrate and potassium permanganate respectively in sequence to react, and then reacting at 30°C to 40°C and 90°C to 100°C respectively in sequence; after the solution gradually turns bright yellow, dropwise adding a H₂O₂ solution, continuing to react for 1 hour to 2 hours, and after the reaction is completed, preparing the graphene oxide by post-treatment.

In some embodiments of the present disclosure, in the materials for preparing the graphene oxide, an input ratio of the graphene to the concentrated sulfuric acid, the phosphorous acid, the sodium nitrate, the potassium permanganate and the H₂O₂ is 3 g: 60 mL: 6 mL: 3 g: 15 g: 70 mL, and the H₂O₂ solution is prepared from H₂O₂ and water with a volume ratio of 7: 8.

In some embodiments of the present disclosure, the step of preparing the reduced graphene oxide by reducing the graphene oxide includes: dispersing a reducing agent in a suspension of the graphene oxide, and stirring at 50°C to 60°C for 24 hours to 30 hours to prepare the reduced graphene oxide.

In some embodiments of the present disclosure, a method for preparing the reduced graphene oxide layer includes: spin-coating a reduced graphene oxide solution on the perovskite layer, and annealing to obtain the reduced graphene oxide layer, where the reduced graphene oxide solution includes the polydopamine and the reduced graphene oxide combined by means of the chemical reaction, or the reduced graphene oxide layer includes the polydopamine and the reduced graphene oxide combined by means of physical blending.

In some embodiments of the present disclosure, a solvent of the reduced graphene oxide solution is isopropanol, and a ratio of a mass of the combination of the polydopamine and the reduced graphene oxide to a volume of the isopropanol ranges from 0.5 mg:1 mL to 2 mg:1 mL.

In some embodiments of the present disclosure, in the process of spin-coating the reduced graphene oxide solution, a humidity ranges from 5% RH to 10% RH, a rotating speed ranges from 3,500 rpm to 5,000 rpm, an acceleration is 0.5 times of the rotating speed, and a spin-coating time ranges from 25 seconds to 35 seconds.

In some embodiments of the present disclosure, in the step of preparing the reduced graphene oxide layer, the annealing refers to: annealing at 100°C to 125°C for 10 minutes to 15 minutes.

In some embodiments of the present disclosure, the perovskite solar cell further includes a substrate or a bottom cell and a hole transport layer arranged on the substrate or the bottom cell, the perovskite layer is located on a surface of the hole transport layer, the perovskite solar cell further includes a positive electrode and a negative electrode, the positive electrode forms an ohmic contact with the substrate or the bottom cell, and the negative electrode forms an ohmic contact with the electron transport layer.

In some embodiments of the present disclosure, the hole transport layer is a nickel oxide layer, and a thickness of the hole transport layer ranges from 100 nm to 150 nm.

In some embodiments of the present disclosure, a thickness of the perovskite layer ranges from 800 nm to 1,000 nm.

In some embodiments of the present disclosure, the electron transport layer is C₆₀ or a derivative thereof, and a thickness of the electron transport layer ranges from 250 nm to 300 nm.

In some embodiments of the present disclosure, the perovskite solar cell further includes a buffer layer, and the buffer layer is located on a surface of the electron transport layer away from the reduced graphene oxide layer.

Further, the present disclosure further provides a preparation method for the perovskite solar cell according to any one of the embodiments above, including the following steps:
providing a substrate or a bottom cell;
preparing a hole transport layer on the substrate or the bottom cell;
preparing the perovskite layer on the hole transport layer;
preparing the reduced graphene oxide layer on the perovskite layer;
preparing the electron transport layer on the reduced graphene oxide layer; and
preparing a positive electrode and a negative electrode.

In some embodiments of the present disclosure, the perovskite layer is prepared on the hole transport layer by a solution spin-coating method, and the electron transport layer is prepared on the reduced graphene oxide layer.

### BRIEF DESCRIPTION OF THE DRAWINGS

In order to illustrate the technical solutions in the embodiments of the present disclosure more clearly, the accompanying drawings used in the embodiments will be briefly described below. Apparently, the accompanying drawings in the following description are merely some embodiments of the present disclosure. For a person of ordinary skill in the art, other accompanying drawings may also be obtained based on these drawings without creative efforts.
FIG. 1 is a schematic structural diagram of a perovskite solar cell disclosed by the embodiments of the present disclosure.
FIG. 2 is a schematic diagram showing molecular structures of graphene oxide and reduced graphene oxide disclosed by the embodiments of the present disclosure.
FIG. 3 is an SEM graph of the reduced graphene oxide disclosed by the embodiments of the present disclosure.

Reference numerals: 1 - transparent conductive glass substrate; 2 - hole transport layer; 3 - perovskite layer; 4 - reduced graphene oxide layer; 5 - electron transport layer; 7 - negative electrode; and 8 - positive electrode.

### DETAILED DESCRIPTION OF THE EMBODIMENTS

The following clearly and completely describes the technical solutions in the embodiments of the present disclosure with reference to the accompanying drawings in the embodiments of the present disclosure. Apparently, the described embodiments are only some but not all of the embodiments of the present disclosure. All other embodiments obtained by a person of ordinary skill in the art based on the embodiments of the present disclosure without creative efforts shall fall within the protection scope of the present disclosure.

The present disclosure will be further described hereinafter in detail with reference to the embodiments and the accompanying drawings.

According to a first aspect, the present disclosure discloses a perovskite solar cell and a preparation method therefor. The perovskite solar cell includes: a perovskite layer 3, an electron transport layer 5 and a reduced graphene oxide layer 4. The reduced graphene oxide layer 4 is located between the perovskite layer 3 and the electron transport layer 5. The reduced graphene oxide layer 4 includes polydopamine and reduced graphene oxide combined by means of a chemical reaction, or polydopamine and reduced graphene oxide combined by means of physical blending.

When the polydopamine and the reduced graphene oxide are combined by means of the chemical reaction or combined by means of physical blending and used as an intermediate layer inserted between the perovskite layer 3 and the electron transport layer 5, a synergistic effect of the polydopamine and the reduced graphene oxide on modifying and passivating an interface defect between the perovskite layer 3 and the electron transport layer 5 may be exerted, and a stability and an electron transport efficiency of the perovskite solar cell may be significantly improved. Moreover, compared with the way that the polydopamine and the reduced graphene oxide are combined by means of physical blending and used as the intermediate layer between the perovskite layer 3 and the electron transport layer 5, the way that the polydopamine and the reduced graphene oxide are combined by means of the chemical reaction can better improve a synergistic performance of the polydopamine and the reduced graphene oxide on modifying and passivating the interface defect between the perovskite layer 3 and the electron transport layer 5, and improve the stability and the electron transport efficiency of the perovskite solar cell, which improves an energy conversion efficiency and an electron mobility of the perovskite solar cell more obviously.

In addition, the reduced graphene oxide itself is an excellent electron acceptor, which may improve an extraction efficiency of free electrons by the electron transport layer 5. Moreover, the reduced graphene oxide has a honeycomb network structure, which may well carry the electron transport layer 5, and can block moisture in an environment and reduce an influence of external moisture on a stability of the perovskite layer 3.

The combination of the polydopamine and the perovskite layer 3 may open up additional electron channels, which can provide more channels for electron transport by combining with electron channels of the electron transport layer 5, which has a better effect on improving an electron transfer ability of the perovskite solar cell. Moreover, there are a large number of functional groups on a surface of the polydopamine, including primary amine, tertiary amino group and catechol group, which may be used as anchor points for fixing metal ions and active sites for in-situ growth, and may prompt the reduced graphene oxide to be closely attached to a surface of the perovskite layer 3 through a joint action of strong covalent bonds, noncovalent bonds and π-π * bonds, and improve an adhesion stability of the reduced graphene oxide layer 4. Furthermore, the polydopamine has an excellent daylighting ability and an excellent conductivity, and has good light trapping and electron migration ability, which may effectively improve optical and electrical properties of matrix materials.

In some embodiments, a mass ratio of the polydopamine to the reduced graphene oxide ranges from 0.01:100 to 10:100.

When the polydopamine and the reduced graphene oxide are combined by means of physical blending manner according to the above mass ratio, the reduced graphene oxide layer 4 has excellent effects on electron extraction. When the mass ratio of the polydopamine to the reduced graphene oxide is too large or too small, the synergistic effect of the polydopamine and the reduced graphene oxide decreases, which is not conducive to the electron extraction by the reduced graphene oxide layer 4, thus reducing the energy conversion efficiency and the electron mobility of the perovskite solar cell.

When the polydopamine and the reduced graphene oxide are combined in the chemical reaction mode according to the mass ratio above, the obtained polydopamine-modified reduced graphene oxide has better dispersibility in the isopropanol, and the polydopamine-modified reduced graphene oxide has better wettability to the perovskite layer 3, which is beneficial to improving adhesion between the reduced graphene oxide layer 4 and the perovskite layer 3. When the mass ratio of the polydopamine to the reduced graphene oxide is too large, the dispersibility of the polydopamine-modified reduced graphene oxide becomes poor, and it is difficult to infiltrate the perovskite layer 3, decreasing an adhesion performance with the perovskite layer 3, which is not conducive to electron transport. When the mass ratio of the polydopamine to the reduced graphene oxide is too small, the synergistic effect between the polydopamine and the reduced graphene oxide is significantly reduced, which is also not conducive to electron transport, resulting in the decrease of the energy conversion efficiency and the electron mobility of the perovskite solar cell. For example, the mass ratio of the to the reduced graphene oxide is 0.01: 100, 0.5: 100, 1: 100, 3: 100, 4: 100, 5: 100, 6: 100, 7: 100, 9: 100, 10: 100, and the like.

Preferably, a mass ratio of the polydopamine to the reduced graphene oxide ranges from 4 to 6: 100, and the synergistic effect of the polydopamine and the reduced graphene oxide with this mass ratio is better, which further improves the energy conversion efficiency and the electron mobility of the perovskite solar cell.

Preferably, the polydopamine is prepared from any one of dopamine hydrochloride, 5-hydroxydopamine hydrochloride or 6-hydroxydopamine hydrobromide.

In some embodiments, a thickness of the reduced graphene oxide layer 4 ranges from 15 nm to 20 nm.

The reduced graphene oxide layer 4 with the above thickness has a good electron extraction ability, a good ability of passivating the perovskite layer 3 and a good ability of blocking moisture in an external environment. If the thickness is too low, the electron extraction ability, the ability of passivating the perovskite layer 3 and the ability of blocking the moisture in the external environment will decrease, while if the thickness is too large, it will easily block light penetration and reduce a light absorption ability of a perovskite light absorption layer. Illustratively, the thickness of the reduced graphene oxide layer 4 is 15 nm, 16 nm, 17 nm, 18 nm, 19 nm, 20 nm, or the like.

In some embodiments, a method for preparing the polydopamine-modified reduced graphene oxide by reacting the polydopamine with the reduced graphene oxide includes: dissolving the polydopamine and the reduced graphene oxide in isopropanol and stirring for reaction, where a mass ratio of the polydopamine to the reduced graphene oxide ranges from 0.01:100 to 10:100; and after the reaction, washing and drying the mixture to obtain the polydopamine-modified reduced graphene oxide.

In the reaction of the polydopamine-modified reduced graphene oxide, due to a lamellar structure of the reduced graphene oxide above, the reduced graphene oxide can well carry the polydopamine, which promotes the reaction and combination of the reduced graphene oxide and the polydopamine with the mass ratio above and produces a crosslinking effect. The polydopamine-modified reduced graphene oxide prepared by the crosslinking reaction can fully combine advantages of the polydopamine and the reduced graphene oxide. The combination of the polydopamine and the reduced graphene oxide can produce a better synergistic effect, which is more excellent in improving the conversion efficiency and the mobility of the perovskite solar cell.

In some embodiments, in the step of preparing the polydopamine-modified reduced graphene oxide, after the reduced graphene oxide is mixed with the isopropanol, the mixture is dispersed by ultrasound first, and then the polydopamine is added.

Firstly, the reduced graphene oxide is fully dispersed in the isopropanol, and then the polydopamine is added to react with the uniformly dispersed reduced graphene oxide, which is beneficial to better reaction and combination of the polydopamine and the reduced graphene oxide, and solves a subsequent problem that the reduced graphene oxide is difficult to be uniformly dispersed due to the reaction and combination of the polydopamine and the unevenly dispersed reduced graphene oxide in advance.

In some embodiments, in the step of preparing the polydopamine-modified reduced graphene oxide, after the polydopamine, the reduced graphene oxide and the isopropanol are mixed, a pH regulator is added to adjust a pH value to a range from 8 to 9, and the pH regulator includes one or more of sodium hydroxide, ammonia water and sodium carbonate. And/or, a reaction temperature for preparing the polydopamine-modified reduced graphene oxide ranges from 75°C to 85°C, and a reaction time for preparing the polydopamine-modified reduced graphene oxide ranges from 20 hours to 28 hours.

The polydopamine and the reduced graphene oxide above are fully dispersed in the isopropanol, and a reaction activity is high under the pH and the reaction temperature environment above. A phenolic hydroxyl group of catechol in the polydopamine can be better combined with an oxygen-containing group such as carboxylic acid on a surface of the reduced graphene oxide, thereby improving a conversion rate of the polydopamine-modified reduced graphene oxide.

Further, it is found in the present disclosure that, compared with ordinary graphene oxide, such as preparing graphene oxide by a Hummers method and preparing graphene oxide by an improved Hummers method, the prepared graphene oxide has a higher degree of oxidation, while using graphene oxide with a higher degree of oxidation as a raw material for preparing reduced graphene oxide, the prepared reduced graphene oxide has stronger reducibility, which can better passivate the defect at the interface between the perovskite layer 3 and the electron transport layer 5 and improve the electron transport efficiency of the perovskite solar cell.

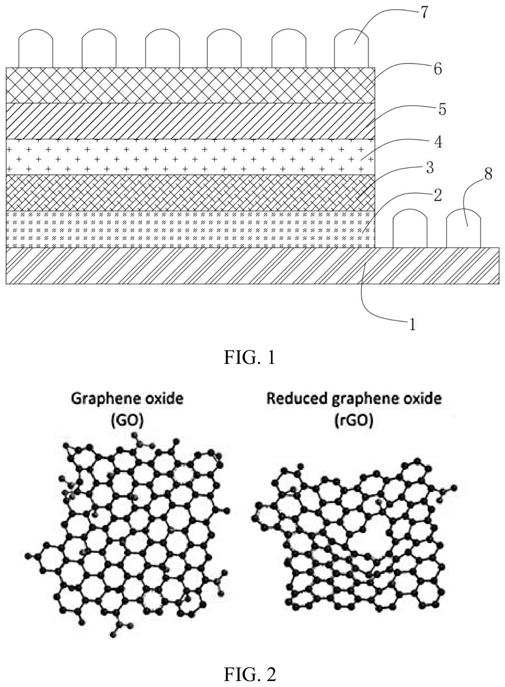

Specifically, the preparation method of the graphene oxide includes: dispersing graphene in a mixed solution of concentrated sulfuric acid and phosphorous acid, adding sodium nitrate and potassium permanganate respectively in sequence to react, and then reacting at 30°C to 40°C and 90°C to 100°C respectively in sequence; and after the solution gradually turns bright yellow, dropwise adding a H₂O₂ solution, continuing to react for 1 hour to 2 hours, and after the reaction is completed, preparing the graphene oxide by post-treatment. A molecular structure schematic diagram of the graphene oxide is shown in FIG. 2.

A concentrated sulfuric acid with a mass fraction of 95% or more may be selected, and a phosphorous acid with a mass fraction of 65% or more may be selected. The concentrated sulfuric acid with a mass fraction of 95% and the phosphorous acid with a mass fraction of 65% are preferred in the embodiments of the present disclosure.

In the preparation of the graphene oxide, a mixed acid system of the concentrated sulfuric acid and the phosphorous acid is used to improve an oxidation effect of graphene, so as to prepare graphene oxide with more oxidation groups and higher oxidation ability than the ordinary graphene oxide. After the reduction treatment, the oxidation groups in graphene oxide are reduced to form reduced graphene oxide with more reduction groups and stronger reduction ability, thus enhancing the ability of passivating the perovskite layer 3 of the reduced graphene oxide.

Meanwhile, after the above oxidation treatment, there are more oxygen-containing groups in the reduced graphene oxide. The increase of these oxygen-containing groups can provide more reactive attachment sites for the preparation of the polydopamine-modified reduced graphene oxide, promote the full reaction of the polydopamine and the reduced graphene oxide, and improve a crosslinking degree of the two, thus preparing the polydopamine-modified reduced graphene oxide with excellent synergistic effect.

Furthermore, after the reaction at 95°C, the H₂O₂ solution is further dropwise added for an oxidation reaction. Combined with an ultrasonic treatment, it is beneficial to increase a distance between graphene oxide graphene lamellae, so that more lamellae can be separated from the graphene oxide, and then the reduced graphene oxide with dense lamellar structure can be prepared after subsequent reduction.

Specifically, in the materials for preparing the graphene oxide, an input ratio of the graphene to the concentrated sulfuric acid, the phosphorous acid, the sodium nitrate, the potassium permanganate and the H₂O₂ is 3 g: 60 mL: 6 mL: 3 g: 15 g: 70 mL, and the H₂O₂ solution is prepared from H₂O₂ and water with a volume ratio of 7: 8.

The graphene with the above ratio is mixed with a mixed solution of the concentrated sulfuric acid and the phosphorous acid, the sodium nitrate, the potassium permanganate and the H₂O₂ solution, and the prepared graphene oxide has a high degree of oxidation, which is beneficial to the preparation of the reduced graphene oxide with strong reducibility and good ability for passivating the perovskite layer 3.

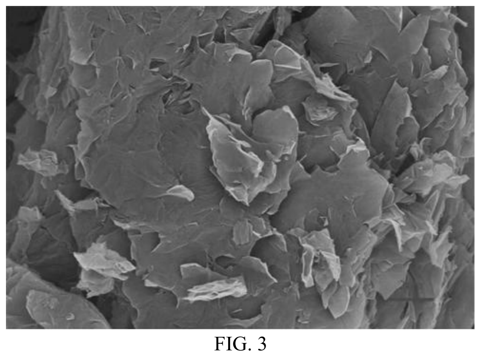

The step of preparing the reduced graphene oxide by reducing the graphene oxide includes: dispersing a reducing agent in a suspension of the graphene oxide, and stirring at 50°C to 60°C for 24 hours to 30 hours to prepare the reduced graphene oxide. A molecular structure diagram of the reduced graphene oxide is shown in FIG. 2, and a surface morphology SEM graph is shown in FIG. 3.

A mass ratio of the reducing agent to the graphene oxide ranges from 4:0.9 to 6:0.9. Preferably, the reducing agent includes one or more of hydration trap, sodium borohydride, hydrogen, ammonia, vitamin C, potassium hydroxide, sodium oxide, dimethyl trap, p-phenylenediamine and hydroiodic acid.

The oxygen-containing functional groups of the reduced graphene oxide are reduced by the reducing agent above, and the prepared reduced graphene oxide has better reducibility and stronger ability for passivating the defect of the perovskite layer 3, which is beneficial to obtaining the perovskite layer 3 with better crystallization performance and improving the stability of the perovskite layer 3.

In some embodiments, a method for preparing the reduced graphene oxide layer 4 includes: spin-coating a reduced graphene oxide solution on the perovskite layer 3, and annealing to obtain the reduced graphene oxide layer 4, where the reduced graphene oxide solution includes the polydopamine and the reduced graphene oxide combined by means of the chemical reaction, or includes the polydopamine and the reduced graphene oxide combined by means of physical blending.

In some embodiments, a solvent of the reduced graphene oxide solution is isopropanol, and a ratio of a mass of the polydopamine-modified reduced graphene oxide to a volume of the isopropanol ranges from 0.5 mg:1 mL to 2 mg:1 mL.

The polydopamine has poor solubility, which is difficult to dissolve in most alcohol solvents such as ethanol, and is difficult to dissolve with the reduced graphene oxide at the same time in most solvents. It is found in the present disclosure that using the isopropanol as the solvent can disperse both the polydopamine and the reduced graphene oxide, which creates very favorable conditions for the full reaction and combination of the polydopamine and the reduced graphene oxide, and the isopropanol is not easy to damage the perovskite layer 3 and is not easy cause defects in the perovskite layer 3 to affect the stability of the perovskite layer 3, so the perovskite layer 3 can maintain good stability.

Moreover, the reduced graphene oxide solution with the above concentration has better wettability and covering effect on the perovskite layer 3, and the prepared reduced graphene oxide layer 4 has higher uniformity and better quality. When the concentration of the reduced graphene oxide solution is too high, the wettability of the reduced graphene oxide solution to the perovskite layer 3 is poor, while when the concentration is too low, it is easy to cause the solution not to completely cover the perovskite layer 3, both of which will decrease uniformity and quality of a film layer.

In some embodiments, in the process of spin-coating the reduced graphene oxide solution, a humidity ranges from 5% RH to 10% RH, a rotating speed ranges from 3,500 rpm to 5,000 rpm, an acceleration is 0.5 times of the rotating speed, and a spin-coating time ranges from 25 seconds to 35 seconds.

Preparing the reduced graphene oxide layer 4 under the above humidity is beneficial to maintaining a crystallization quality and the stability of the perovskite layer 3 and reducing an influence of spin-coating the reduced graphene oxide solution on the perovskite layer 3. By controlling the rotating speed, the acceleration and the time of the spin-coating, the reduced graphene oxide layer 4 can be evenly covered on the perovskite layer 3, and an excess solution can also be thrown off a surface of the film by spin-coating, so that the reduced graphene oxide layer 4 with high thickness uniformity and film forming quality can be prepared. Illustratively, the humidity is 5% RH, 6.5% RH, 8.5% RH, 10% RH, or the like, the rotating speed is 3,500 rpm, 5,000 rpm, 3,500 rpm, 5,000 rpm, 3,500 rpm, 5,000 rpm, or the like, and the spin-coating time is 25 seconds, 28 seconds, 30 seconds, 32 seconds, 34 seconds, or the like.

In some embodiments, in the step of preparing the reduced graphene oxide layer 4, the annealing refers to annealing at 100°C to 125°C for 10 minutes to 15 minutes.

Annealing at the above temperature is beneficial for promoting the attachment of the reduced graphene oxide to a surface of a perovskite absorption layer, and fully removing the excess solvent at the same time. If the annealing temperature is too low and the annealing time is too short, the solvent cannot be completely volatilized and removed, which will affect a quality of the reduced graphene oxide film layer and a device filling factor. Too high annealing temperature and too long annealing time will lead to thermal decomposition and destruction of a pre-perovskite absorption layer. For example, the annealing temperature is 100°C, 105°C, 110°C, 115°C, 120°C, 125°C, or the like, and the annealing time is 10 minutes, 12.5 minutes, 13.5 minutes, 15 minutes, or the like. The technological parameters are not specifically limited in the embodiment.

In some embodiments, the perovskite solar cell further includes a substrate or a bottom cell, where the substrate may be a transparent conductive glass substrate 1, and the perovskite solar cell further includes a hole transport layer 2 arranged on the substrate or the bottom cell. The perovskite layer 3 is located on a surface of the hole transport layer 2, and the perovskite solar cell further includes a positive electrode 8 and a negative electrode 7. The positive electrode 8 forms an ohmic contact with the substrate or the bottom cell, and the negative electrode 7 forms an ohmic contact with the electron transport layer 5.

In some embodiments, the hole transport layer 2 is a nickel oxide layer, a thickness of the hole transport layer 2 ranges from 100 nm to 150 nm, and/or a thickness of the perovskite layer 3 ranges from 800 nm to 1,000 nm, and/or the electron transport layer 5 is C₆₀ or a derivative thereof, and a thickness of the electron transport layer ranges from 250 nm to 300 nm.

In some embodiments, the perovskite solar cell further includes a buffer layer, and the buffer layer is located on a surface of the electron transport layer 5 away from the reduced graphene oxide layer 4.

According to a second aspect, the present disclosure provides a preparation method for a perovskite solar cell, including the following steps:
providing a substrate or a bottom cell;
preparing a hole transport layer 2 on the substrate or the bottom cell;
preparing a perovskite layer 3 on the hole transport layer 2;
preparing a reduced graphene oxide layer 4 on the perovskite layer 3;
preparing an electron transport layer 5 on the reduced graphene oxide layer 4; and
preparing a positive electrode 8 and a negative electrode 7 to obtain the perovskite solar cell mentioned in the first aspect.

In some embodiments, a method for preparing the hole transport layer 4 includes: using a nickel oxide sputtering target with a content ranging from 99.9% to 99.999%, and plating the film for 10 times to 15 times under a process pressure ranging from 0.5 Pa to 0.6 Pa and a process atmosphere of Ar:O₂ = 500:5 to 700:5 to obtain the hole transport layer 2.

In some embodiments, the perovskite layer 3 is prepared on the hole transport layer 2 by a solution spin-coating method, and the electron transport layer 5 is prepared on the reduced graphene oxide layer 4.

The technical solutions of the present disclosure will be further explained with more specific embodiments and drawings.

### Example 1

Example 1 of the present disclosure provides a perovskite solar cell. The perovskite solar cell includes:
a transparent conductive glass substrate, where the transparent conductive glass substrate is indium tin oxide and a thickness of the transparent conductive glass substrate is 1,100 nm;
a hole transport layer stacked on the transparent conductive glass substrate, where the hole transport layer is a nickel oxide layer with a thickness of 125 nm;
a perovskite layer stacked on one side of the hole transport layer away from the transparent conductive glass, where a thickness of the perovskite layer is 900 nm;
a reduced graphene oxide layer stacked on one side of the perovskite light absorption layer away from the transparent conductive glass, where the reduced graphene oxide layer is a mixed layer of polydopamine and reduced graphene oxide with a thickness of 17.5 nm;
an electron transport layer stacked on one side of the reduced graphene oxide away from the transparent conductive glass, where the electron transport layer is a C₆₀ layer with a thickness of 25 nm;
a buffer layer stacked on the electron transport layer, where the buffer layer is made of 2,9-dimethyl-4,7-diphenyl-1,10-phenanthroline; and
electrodes, where the electrodes include a silver positive electrode and a silver negative electrode, where a thickness of the silver positive electrode and a thickness of the silver negative electrode are 275 nm, the silver positive electrode forms an ohmic contact with the transparent conductive glass substrate and the silver negative electrode forms an ohmic contact with the buffer layer.

A preparation method for a perovskite solar cell includes the following steps.

Providing a transparent conductive glass substrate, and performing ultraviolet ozone activation on the transparent conductive glass substrate for 15 minutes to decompose impurities of the transparent conductive glass substrate.

Preparing a hole transport layer on the transparent conductive glass substrate by magnetron sputtering, where, specifically, in the process of preparing the hole transport layer, a NiOₓ sputtering target with a content of 99.99% was used at a process pressure of 0.55 Pa, a process atmosphere of Ar:O₂ = 500:5 to 700:5, and a coating transmission times of 12.

Preparing a perovskite layer on the hole transport layer by a solution spin-coating method.

Preparing a reduced graphene oxide layer on the perovskite layer, where, specifically, 100 mg of reduced graphene oxide was dissolved in 100 mL of isopropanol, and the reduced graphene oxide solution was prepared by ultrasonic for 1 hour to fully disperse the reduced graphene oxide, and then 5 mg of polydopamine was added and stirred evenly in a blender to fully disperse the reduced graphene oxide and the polydopamine to prepare the reduced graphene oxide solution; and the polydopamine was prepared by using dopamine hydrochloride ((HO)₂C₆H₃CH₂CH₂NH₂·HCl, CAS: 62-31-7).

Sucking 50 µL to 100 µL of reduced graphene oxide solution by a pipette and spin-coating the reduced graphene oxide solution on the perovskite layer at a spin-coating atmosphere of 5% RH, a spin-coating speed of 4,000 rpm, an acceleration of 2,000 rpm/s, and a spin-coating time of 30 seconds, and then annealing at 100°C for 10 minutes to obtain the reduced graphene oxide layer.

A preparation method of the reduced graphene oxide above was as follows:
Preparing graphene oxide: 3 g of powdered graphite was weighed and put into a three-necked flask, added with 60 mL of mixed solution (60 mL: 6 mL) composed of 60 mL of H₂SO₄ and 6 mL of H₃PO₃, stirred magnetically for 1 hours, then added with 3 g of NaNO₃ to continue the reaction for 1 hour, then 15 g of KMnO₄ was weighed and slowly added into the three-necked flask for several times, and stirred continuously for reaction for 2 hours. After naturally cooling to room temperature, the mixture was heated to 35°C in an oil bath pot and then stirred for 2 hours, subsequently the three-necked flask was added with 150 mL of deionized water and transferred to an oil bath at 95°C for 2 hours. After the solution gradually turned bright yellow, 70 mL of H₂O₂ solution was dropwise added slowly and the reaction continued for 1 hour, where the H₂O₂ solution was prepared from H₂O₂ and H₂O according to a mass ratio of 7:8. Centrifugation was performed to collect the separated solution, and then the solution was rinsed with 5% dilute hydrochloric acid solution and deionized water until pH=7. Then, the solution was diluted to 1,000 mL with deionized water, continuously sonicated in an ultrasonic cleaner for 4 hours, centrifuged to collect and dry at 60°C to obtain the graphene oxide.

Preparing reduced graphene oxide: 2 g of graphene oxide was dispersed by ultrasonic dispersion in 500 mL of deionized water to obtain 4 mg/mL suspension, and then diluted to 3 mg/mL. 5 g of p-toluenesulfonyl hydrazide was added to 30 mL of diluted graphene oxide dispersion, and stirred at 60°C for 24 hours to perform a reduction process. Then, the obtained dispersion was filtered and washed with water and N,N-dimethylformamide respectively to remove the p-toluenesulfonyl hydrazide. The dispersion was centrifuged and collected, and dried in an oven at 60°C for 12 hours to obtain the reduced graphene oxide.

Preparing an electron transport layer on one side of the reduced graphene oxide away from the transparent conductive glass substrate by using an evaporation method.

Preparing a BCP buffer layer on the electron transport layer by a solution spin-coating method, where a preparation method for the BCP buffer layer was as follows: dissolving 0.5 mg of BCP in 5 mL of ethanol solvent to obtain a protective layer solution of BCP with a mass fraction of 0.5 mg/mL, spin-coating the protective layer solution on the electron transport layer at 4,000 rpm for 30 seconds, and annealing at 100°C for 10 minutes at a relative humidity of 5% to obtain the buffer layer.

Vaporizing a layer of silver as a silver negative electrode on the buffer layer and vaporizing a layer of silver as a silver positive electrode on the transparent conductive glass substrate.

### Example 2

Example 2 of the embodiments of the present disclosure provides a perovskite solar cell, which was different from Example 1 in that the reduced graphene oxide layer was a polydopamine-modified reduced graphene oxide layer.

A preparation method for the polydopamine-modified reduced graphene oxide layer was specifically as follows:
Dissolving 100 mg of reduced graphene oxide powder in 100 mL of isopropanol, sonicating for 1 hour until the powder was fully dispersed, then adding 5 mg of dopamine, which was prepared from dopamine hydrochloride ((HO)₂C₆H₃CH₂CH₂NH₂·HCl, CAS: 62-31-7), adjusting a pH to 8.5 with a NaOH solution to obtain a mixed solution, observing that a color of the mixed solution changed from milky white to grayish brown, placing the mixed solution in an oil bath pot at 80°C and stirring magnetically for 24 hours, removing excess ions and unreacted polydopamine by repeated washing and centrifugation, and drying in an oven at 60°C for 12 hours to obtain the polydopamine-modified reduced graphene oxide.

Dissolving the polydopamine-modified reduced graphene oxide above in 100 mL of isopropanol, and stirring in a blender for 24 hours to fully disperse the reduced graphene oxide to prepare a reduced graphene oxide solution.

Sucking 50 µL to 100 µL of reduced graphene oxide solution by a pipette and spin-coating the reduced graphene oxide solution on the perovskite layer at a spin-coating atmosphere of 5% RH, a spin-coating speed of 4,000 rpm, an acceleration of 2,000 rpm/s, and a spin-coating time of 30 seconds, and then annealing at 100°C for 10 minutes to obtain the polydopamine-modified reduced graphene oxide layer.

### Example 3

Example 3 of the present disclosure provides a perovskite solar cell, which was different from Example 2 in that a dosage of the polydopamine in the preparation process of the polydopamine-modified reduced graphene oxide was 0.5 mg.

### Example 4

Example 4 of the present disclosure provides a perovskite solar cell, which was different from Example 2 in that a dosage of the polydopamine in the preparation process of the polydopamine-modified reduced graphene oxide was 3 mg.

### Example 5

Example 5 of the present disclosure provides a perovskite solar cell, which was different from Example 2 in that a dosage of the polydopamine in the preparation process of the polydopamine-modified reduced graphene oxide was 10 mg.

### Example 6

Example 6 of the present disclosure provides a perovskite solar cell, which was different from Example 2 in that a concentration of the reduced graphene oxide solution was 0.5 mg/mL.

### Example 7

Example 7 of the present disclosure provides a perovskite solar cell, which was different from Example 2 in that a concentration of the reduced graphene oxide solution was 2 mg/mL.

### Example 8

Example 8 of the present disclosure provides a perovskite solar cell, which was different from Example 2 in that the polydopamine was prepared by 5-hydroxydopamine hydrochloride ((HO)₃C₆H₂CH₂CH₂NH₂·HCl, CAS: 5720-26-3)

### Example 9

Example 9 of the present disclosure provides a perovskite solar cell, which was different from Example 2 in that the polydopamine was prepared by 6-hydroxydopamine hydrobromide ((HO)₃C₆H₂CH₂CH₂NH₂·HBr, CAS: 636-00-0).

### Comparative Example 1

Comparative Example 1 of the present disclosure provides a perovskite solar cell, which was different from Example 1 in that a reduced graphene oxide layer was not prepared between the perovskite layer and the electron transport layer.

### Comparative Example 2

Comparative Example 2 of the present disclosure provides a perovskite solar cell, which was different from Example 1 in that the reduced graphene oxide layer only contained reduced graphene oxide and did not contain the polydopamine, specifically:
dissolving 100 mg of reduced graphene oxide in 100 mL of isopropanol, and stirring in a blender for 24 hours to fully disperse the reduced graphene oxide to prepare a reduced graphene oxide solution; and sucking 50 µL to 100 µL of reduced graphene oxide solution by a pipette and spin-coating the reduced graphene oxide solution on the perovskite layer at a spin-coating atmosphere of 5% RH, a spin-coating speed of 4,000 rpm, an acceleration of 2,000 rpm/s, and a spin-coating time of 30 seconds, and then annealing at 100°C for 10 minutes to obtain the reduced graphene oxide layer.

### Comparative Example 3

Comparative Example 3 of the present disclosure provides a perovskite solar cell, which was different from Example 1 in that an electron transport layer was not prepared after the reduced graphene oxide layer was prepared.

### Comparative Example 4

Comparative Example 4 of the present disclosure provides a perovskite solar cell, which was different from Example 2 in that an electron transport layer was not prepared after the reduced graphene oxide layer was prepared.

### Experiment 1

The reduced graphene oxide of Example 1 was scanned by SEM to obtain FIG. 3.

As can be seen from FIG. 3, the reduced graphene oxide has a lamellar structure, which can well carry the polydopamine, which is beneficial to full contact and reaction between the polydopamine and the reduced graphene oxide. Meanwhile, the lamellar structure of the reduced graphene oxide is compact, and a hydrophobic effect of the reduced graphene oxide is good, which can physically block moisture in an environment on an interface of a perovskite layer, and can reduce the moisture in the environment from entering the perovskite layer and being hydrolyzed by the moisture in the environment, thus improving a stability of the perovskite layer.

### Experiment 2

Energy conversion efficiency and electron mobilities of the perovskite solar batteries above were tested. The energy conversion efficiency was tested by an off-line IV test system, and the electron mobility was tested by a Hall test. The test results are shown in Table 1.

**Table 1**

| | Energy conversion efficiency (%) | Electron mobility (cm²/Vsec) |
|---|---|---|
| Example 1 | 23.28 | 5.28×10⁻² |
| Example 2 | 26.65 | 9.61×10⁻² |
| Example 3 | 24.68 | 6.56×10⁻² |
| Example 4 | 25.32 | 7.25×10⁻² |
| Example 5 | 24.94 | 7.18×10⁻² |
| Example 6 | 24.52 | 6.48×10⁻² |
| Example 7 | 24.65 | 6.51×10⁻² |
| Example 8 | 25.34 | 7.31×10⁻² |
| Example 9 | 25.05 | 7.15×10⁻² |
| Comparative Example 1 | 21.96 | 3.61×10⁻² |
| Comparative Example 2 | 22.86 | 4.79×10⁻² |
| Comparative Example 3 | 20.32 | 2.79×10⁻² |
| Comparative Example 4 | 20.79 | 2.98×10⁻² |

As can be seen from the data in Table 1, compared with Comparative Example 1, the energy conversion efficiency of Example 1 of the present disclosure is increased by 1.32%, and the electron mobility of Example 1 is increased by 1.67×10⁻². The energy conversion efficiency of Example 2 is increased by 4.69%, and the electron mobility of Example 2 is increased by 6.00×10⁻². It is proven that the addition of the reduced graphene oxide and the polydopamine between the perovskite layer and the electron transport layer as a separate film layer by means of physical combination or chemical combination can reduce a large number of defects at the interface between the perovskite layer and the electron transport layer, and reduce the recombination of electrons at the interface. Meanwhile, an ability of the reduced graphene oxide layer to receive electrons transferred by the perovskite layer is quite excellent, which is conducive to migration of more electrons from the perovskite layer to the electron transport layer, and improves the electron transfer efficiency.

Compared with Comparative Example 2, the energy conversion efficiency of Example 1 is increased by 0.42%, and the electron mobility of Example 1 is increased by 0.49×10⁻². The energy conversion efficiency of Example 2 is increased by 3.79%, and the electron mobility of Example 2 is increased by 4.82×10⁻². It is proven that the addition of polydopamine is conducive to further passivating the defects between the perovskite layer and the electron transport layer, improving the stability of the perovskite layer, and is more conducive to transferring electrons from the perovskite layer to the electron transport layer, thus further improving the electron mobility efficiency.

Compared with Example 1, the energy conversion efficiency of Example 2 is increased by 3.37%, and the electron mobility of Example 2 is increased by 4.33×10⁻². It can be seen that compared with the combination of physical blending, the polydopamine and the reduced graphene oxide are combined by means of a chemical reaction. The synergistic effects of the two are very significant, and the effect of improving the energy conversion efficiency and the electron mobility efficiency of the perovskite solar cell is quite excellent.

From the comparison of the data of Example 1 and Comparative Example 3, and the comparison of the data of Example 2 and Comparative Example 4, it can be seen that when the reduced graphene oxide layer is used as an auxiliary film layer and matched with the electron transport layer, the energy conversion efficiency and the electron mobility efficiency of the perovskite solar cell are the best. Lack of an electron transport layer is not conducive to the full play of the effect of the reduced graphene oxide layer.

The perovskite solar cell and the preparation method therefor disclosed by the embodiments of the present disclosure are described in detail above. Specific examples are applied to explain the principle and implementation of the present disclosure herein. The explanations of the above embodiments are only used to help understand the perovskite solar cell and the preparation method therefor of the present disclosure and the core idea thereof. Meanwhile, for a person of ordinary skill in the art, there will be changes in the specific implementation and application scope according to the idea of the present disclosure. To sum up, the contents of this specification should not be construed as limiting the present disclosure.

## Claims

1. A perovskite solar cell, comprising a perovskite layer, an electron transport layer and a reduced graphene oxide layer, wherein the reduced graphene oxide layer is located between the perovskite layer and the electron transport layer, and the reduced graphene oxide layer comprises polydopamine and reduced graphene oxide combined by means of a chemical reaction, or the reduced graphene oxide layer comprises polydopamine and reduced graphene oxide combined by means of physical blending.

2. The perovskite solar cell according to claim 1, wherein a mass ratio of the polydopamine to the reduced graphene oxide ranges from 0.01:100 to 10:100.

3. The perovskite solar cell according to claim 1, wherein a mass ratio of the polydopamine to the reduced graphene oxide ranges from 4:100 to 6:100.

4. The perovskite solar cell according to any one of claims 1 to 3, wherein the polydopamine is prepared from any one of dopamine hydrochloride, 5-hydroxydopamine hydrochloride or 6-hydroxydopamine hydrobromide.

5. The perovskite solar cell according to any one of claims 1 to 4, wherein a thickness of the reduced graphene oxide layer ranges from 15 nm to 20 nm.

6. The perovskite solar cell according to any one of claims 1 to 5, wherein a method for combining the polydopamine and the reduced graphene oxide comprises: dissolving the polydopamine and the reduced graphene oxide in isopropanol and stirring for reaction, wherein a mass ratio of the polydopamine to the reduced graphene oxide ranges from 0.01:100 to 10:100.

7. The perovskite solar cell according to claim 6, wherein in the step of combining the polydopamine with the reduced graphene oxide, after the reduced graphene oxide is mixed with the isopropanol, the mixture is dispersed by ultrasound first, and then the polydopamine is added.

8. The perovskite solar cell according to claim 6 or 7, wherein in the step of combining the polydopamine and the reduced graphene oxide, after the polydopamine, the reduced graphene oxide and the isopropanol are mixed, a pH regulator is added to adjust a pH value to a range from 8 to 9, and the pH regulator comprises one or more of sodium hydroxide, ammonia water and sodium carbonate.

9. The perovskite solar cell according to any one of claims 6 to 8, wherein in the step of combining the polydopamine and the reduced graphene oxide, a reaction temperature ranges from 75°C to 85°C, and a reaction time ranges from 20 hours to 28 hours.

10. The perovskite solar cell according to any one of claims 1 to 9, wherein the reduced graphene oxide is prepared by reducing graphene oxide, and a preparation method for the graphene oxide comprises: dispersing graphene in a mixed solution of concentrated sulfuric acid and phosphorous acid, adding sodium nitrate and potassium permanganate respectively in sequence to react, and then reacting at 30°C to 40°C and 90°C to 100°C respectively in sequence; and after the solution gradually turns bright yellow, dropwise adding a H₂O₂ solution, continuing to react for 1 hour to 2 hours, and after the reaction is completed, preparing the graphene oxide by post-treatment.

11. The perovskite solar cell according to claim 10, wherein in the materials for preparing the graphene oxide, an input ratio of the graphene to the concentrated sulfuric acid, the phosphorous acid, the sodium nitrate, the potassium permanganate and the H₂O₂ is 3 g: 60 mL: 6 mL: 3 g: 15 g: 70 mL, and the H₂O₂ solution is prepared from H₂O₂ and water with a volume ratio of 7: 8.

12. The perovskite solar cell according to claim 10 or 11, wherein the step of preparing the reduced graphene oxide by reducing the graphene oxide comprises: dispersing a reducing agent in a suspension of the graphene oxide, and stirring at 50°C to 60°C for 24 hours to 30 hours to prepare the reduced graphene oxide.

13. The perovskite solar cell according to any one of claims 1 to 12, wherein a method for preparing the reduced graphene oxide layer comprises: spin-coating a reduced graphene oxide solution on the perovskite layer, and annealing to obtain the reduced graphene oxide layer, wherein the reduced graphene oxide solution comprises the polydopamine and the reduced graphene oxide combined by means of the chemical reaction, or the reduced graphene oxide layer comprises the polydopamine and the reduced graphene oxide combined by means of physical blending.

14. The perovskite solar cell according to claim 13, wherein a solvent of the reduced graphene oxide solution is isopropanol, and a ratio of a mass of the combination of the polydopamine and the reduced graphene oxide to a volume of the isopropanol ranges from 0.5 mg:1 mL to 2 mg:1 mL.

15. The perovskite solar cell according to claim 13 or 14, wherein in the process of spin-coating the reduced graphene oxide solution, a humidity ranges from 5% RH to 10% RH, a rotating speed ranges from 3,500 rpm to 5,000 rpm, an acceleration is 0.5 times of the rotating speed, and a spin-coating time ranges from 25 seconds to 35 seconds.

16. The perovskite solar cell according to any one of claims 13 to 15, wherein in the step of preparing the reduced graphene oxide layer, the annealing refers to: annealing at 100°C to 125°C for 10 minutes to 15 minutes.

17. The perovskite solar cell according to any one of claims 1 to 16, wherein the perovskite solar cell further comprises a substrate or a bottom cell and a hole transport layer arranged on the substrate or the bottom cell, the perovskite layer is located on a surface of the hole transport layer, the perovskite solar cell further comprises a positive electrode and a negative electrode, the positive electrode forms an ohmic contact with the substrate or the bottom cell, and the negative electrode forms an ohmic contact with the electron transport layer.

18. The perovskite solar cell according to claim 17, wherein the hole transport layer is a nickel oxide layer, and a thickness of the hole transport layer ranges from 100 nm to 150 nm.

19. The perovskite solar cell according to claim 17 or 18, wherein a thickness of the perovskite layer ranges from 800 nm to 1,000 nm.

20. The perovskite solar cell according to any one of claims 17 to 19, wherein the electron transport layer is C60 or a derivative thereof, and a thickness of the electron transport layer ranges from 250 nm to 300 nm.

21. The perovskite solar cell according to any one of claims 17 to 20, wherein the perovskite solar cell further comprises a buffer layer, and the buffer layer is located on a surface of the electron transport layer away from the reduced graphene oxide layer.

22. A preparation method for the perovskite solar cell according to any one of claims 1 to 21, comprising the following steps:
providing a substrate or a bottom cell;
preparing a hole transport layer on the substrate or the bottom cell;
preparing the perovskite layer on the hole transport layer;
preparing the reduced graphene oxide layer on the perovskite layer;
preparing the electron transport layer on the reduced graphene oxide layer; and
preparing a positive electrode and a negative electrode.

23. The preparation method for the perovskite solar cell according to claim 22, wherein the perovskite layer is prepared on the hole transport layer by a solution spin-coating method, and the electron transport layer is prepared on the reduced graphene oxide layer.
